# EUROPEAN PATENT APPLICATION

(11) **EP 4 822 591 A1**
(43) Date of publication of application: **14.10.2026**
(21) Application number: 26170412.6
(22) Date of filing: 02.04.2026
(51) Int. Cl.: G06K 19/077, G06K 19/07

(54) **TESTING CHARACTERISTICS OF RADIO-FREQUENCY TRANSPONDER ASSEMBLY**

(30) Priority: 04.04.2025 FI 20255320
(71) Applicant: Voyantic OY, 00380 Helsinki (FI)
(72) Inventor: TUOMINEN, Jesse, 00380 Helsinki (FI); PAUKKUNEN, Antti, 00380 Helsinki (FI)
(74) Representative: Laine IP Oy

(57) **Abstract**

There is provided a method for determining at least one characteristic of an RFID tag assembly comprising at least an integrated circuit, IC. The method comprises providing, from a test reader, an RF waveform to the IC (701); receiving, at the test reader, a backscattered reply from the IC, wherein the IC forms the backscattered reply by impressing an information signal on the RF waveform. While receiving the backscattered reply, the RF waveform is altered (703), thereby changing the backscattered reply. The method further comprises measuring the affected backscattered reply, and determining the characteristic based on the measured changed backscattered reply caused by the altering.

## Description

### FIELD

The present invention relates to radio-frequency identification, RFID, technology. The invention relates to a method, a system for testing at least one characteristic of RFID transponder assembly, like an RFID transponder or an integrated circuit of the RFID transponder, and to a computer readable medium for implementing such.

### BACKGROUND

RFID transponders, or tags, may be tested inline during their production process to detect and process deficient units, for example, by marking. Inline testing can pose challenges to the accuracy and speed of the process. Testing should not slow down production and tests must be carried out within a time window which depends on the production line speed. Full characterization of each RFID transponder may not possible as the time window can be very short, such as 5 - 20 ms. Accordingly, compromises may be necessary to adapt testing to the desired production throughput. The faster the tests are, the more thorough the testing and validation can be and the more data can be gathered.

### SUMMARY OF THE INVENTION

An aim of this invention is to enable effective testing of RFID tags and/or RFID tag assemblies comprising at least an of RFID tag IC.

Aspects of the invention are defined by the features of the independent claims. Some embodiments are defined in the dependent claims.

According to a first aspect of the present invention, there is provided a method for determining at least one characteristic of an RFID tag assembly comprising at least an integrated circuit, IC. The method comprises providing, from a test reader, an RF waveform to the IC; receiving, at the test reader, a backscattered reply from the IC, wherein the IC forms the backscattered reply by impressing an information signal on the RF waveform. While receiving the backscattered reply, the RF waveform is altered, thereby causing a change in the backscattered reply. The method further comprises measuring the change in the backscattered reply, and determining the characteristic based on the measured change caused by the altering.

According to a second aspect of the present invention, there is provided a test system for testing characteristic of an RFID tag assembly including an RFID tag IC. The test system is configured to provide an RF waveform to the RFID tag IC; receive a backscattered reply from the RFID tag IC. The RF waveform is altered, while receiving the backscattered reply, and thereby a change in the backscattered reply is caused. The system is configured to measure the change in the backscattered reply; and to determine the characteristic based on the measured change caused by the altering. The test system may comprise means for causing performance according to the first aspect.

According to a third aspect of the present invention there is provided a computer program product, optionally comprising a non-transitory computer readable medium, having stored thereon a set of computer readable instructions that, upon execution by at least one processor, cause method according to the first aspect to be performed.

The RFID tag assembly may comprise at least one of the following: an RFID tag including the IC coupled to an antenna; a part of an RFID tag including at least the IC; an incomplete RFID tag including the IC attached on a media; the IC attached to a conductor loop; the IC attached to a strap; and the IC attached to a conductive element configured to form a radiative antenna, i.e., which will become a radiative antenna at a later stage. The RF waveform may include a modulated command configured to instruct the IC to send the backscattered reply. Providing the RF waveform to the IC may comprise sending the RF waveform through an electrically conductive, physical connection to the RFID tag assembly. Providing the RF waveform to the IC may comprise transmitting the RF waveform wirelessly.

Altering the RF waveform may comprise altering at least one of the following: a power, a frequency, a polarization, a phase, a sideband, a subcarrier, and a spectrum of the RF waveform. Altering the RF waveform may comprise one of: performing a one-time alteration, performing multiple alterations, and performing a continuous alteration.

Altering the RF waveform may comprise reducing a power of the RF waveform; and the characteristic may include one or more of a deactivation threshold of the RFID tag assembly, a sensitivity of the RFID tag assembly, and an activation threshold of the RFID tag assembly. Altering the RF waveform may comprise altering a frequency of the RF waveform; and the characteristic may include one or more of a tuning of the RFID tag assembly, a bandwidth of the RFID tag assembly, and a resonant frequency of the RFID tag assembly.

Measuring the change in the backscattered reply may comprise one or more of: measuring at least one property of the backscattered reply, and measuring a change of the at least one property of the backscattered reply. The at least one property may include at least one of: an amplitude, a phase, a duration, a length, a start, an end, a frequency, a bitrate, and a waveform shape related aspect of the backscattered reply.

The backscattered reply may be recorded in a memory at least one of: before, after, and while altering the RF waveform. Before altering the RF waveform, a power of the RF waveform may be boosted to charge an energy storage of the RFID tag assembly.

The characteristic may include one or more of: a deactivation threshold of the RFID tag assembly, an activation threshold of the RFID tag assembly, a sensitivity of the RFID tag assembly, a charge state of an energy storage of the RFID tag assembly, a tuning of the RFID tag assembly, a bandwidth of the RFID tag assembly, and a resonant frequency of the RFID tag assembly. Determining the characteristic may be based on a power reduction curve of the RF waveform. The discharge time may be determined based on at least a reference test using a second power reduction curve.

### BRIEF DESCRIPTION OF THE DRAWINGS

In the following, embodiments are discussed in more detail with reference to the attached drawings, of which:
Figure 1 illustrates, by way of an example, a production line test arrangement for RFID tag assemblies.
Figure 2 illustrates a chart that illustrates, by way of an example, communication between a tester and an RFID tag assembly.
Figure 3 illustrates, by way of an example, signalling between a tester and an RFID tag assembly.
Figure 4 illustrates a chart that illustrates, by way of an example, communication between a tester and an RFID tag assembly with the tester performing a power ramp-down test.
Figure 5 illustrates, by way of an example, signalling between a tester and an RFID tag assembly with a tester performing waveform altering while the RFID tag is backscattering.
Figures 6a, 6b, 6c, and 6d illustrate, by way of an example, power reduction curves.
Figure 7 illustrates, by way of an example, a method for testing at least one characteristic of an RFID tag assembly.
Figure 8 illustrates, by way of an example, a test apparatus for testing at least one characteristic of an RFID tag assembly.

Figures are presented as illustrative examples and embodiments may not be limited solely to the illustrated parts, but modifications may be made under the scope as defined in the claims. Figures that may not fully present the claimed invention, aim to provide better understanding on the context and relating technical field.

### DESCRIPTION OF EMBODIMENTS

There is provided a test method for radio-frequency identification, RFID transponders, and other types of RFID tag assemblies. A tester or a test system, which may include specialized RFID test equipment and/or an RFID interrogator or an RFID reader, is configured to provide an RF waveform, at a chosen frequency and power, to an RFID tag assembly. The tester may provide the RF waveform through an electrically conductive, physical connection to an RFID tag assembly, or it may send or transmit the RF waveform wirelessly for a transceiver of the RFID tag assembly to receive. The RF waveform may activate the RFID tag assembly by providing sufficient power to enable the RFID tag assembly to receive and reply to commands (i.e., information signals). The RF waveform may itself include a modulated command, instructing the RFID tag assembly to pursue a dialog with, by backscattering a reply to, the tester. The tester may be configured to analyse and/or record the backscattered reply from the RFID tag assembly before, after, or while adjusting or altering some aspect of the RF waveform, during which the RFID tag assembly is backscattering a reply. Aspects of the RF waveform that may be altered includes RF waveform parameters such as power, frequency, and/or phase. The backscattered reply is analysed to measure properties of the backscattered response and/or their change with respect to the RF waveform alterations. This enables assessment of characteristics relating to RFID tag assembly performance more thoroughly, and better detection of variations in RFID tag assembly performance compared to currently used iterative test methods.

A modulated carrier signal, which is generated by a test system, is used for carrying information. A waveform is a representation of a modulated carrier signal, illustrating how the signal changes over time. A carrier is a continuous waveform having a specific frequency and amplitude that remain constant in the absence of any modulation. A command may refer to an information signal, which is used to modulate a carrier wave. Applying a modulation changes the waveform in accordance with the modulation. An RFID tag assembly is able to modulate a (received) carrier signal, for example by modulating its amplitude, frequency and/or phase.

Analysing RFID tag backscatter while altering the RF waveform enables RFID tag characteristics of an RFID tag assembly to be measured under different RF waveform features, or feature values, during a single tester-tag assembly communication cycle. This avoids having to test RFID tag assembly characteristics separately at different RF waveform feature values. For example, if the RF waveform power is altered, it is possible to measure the RFID tag assembly backscatter characteristics at different RF waveform power levels. This may allow, for example, RFID tag assembly sensitivity to be assessed, to detect defective RFID tag assemblies which fail to meet specifications. Being able to run tests using multiple RF waveform feature values during a single tester-tag assembly communication cycle saves time in comparison to conventional, iterative test methods. This enables inline testing of RFID tag assemblies, along the production process, to either maintain a higher throughput or to collect more characteristic data on RFID tag assemblies in a high-speed production process where the time window available for testing can be very small. It also enables reduced susceptibility for RFID tag assembly movement during the test, because RFID tag assembly position may change less during a fast test.

An RFID tag assembly may refer to an RFID tag comprising an integrated circuit, IC, and an antenna; or to a part of RFID tag comprising at least an IC. For example, incomplete RFID tags may be tested after the IC is attached to a conductor loop, a strap or to a conductive element, before the RFID tag is fully assembled. The strap may be, for example, a carrier with conductive elements configured to later couple to other elements to form a radiative antenna. The conductive component may be, for example, a component which will become a radiative antenna of the RFID tag at a later stage. RFID tag assemblies, or RFID transponder assemblies, also referred to herein as tag assemblies, may be passive ultra-high frequency, UHF, tag assemblies, or passive high frequency, HF, tag assemblies.

Passive RFID tag assemblies do not have a battery, but instead harvest energy from an RF waveform provided by an RFID reader or tester. In addition, passive RFID tag assemblies do not actively transmit replies. Instead, a passive RFID tag assembly replies by selectively reflecting (backscattering) an already-present RF waveform based on an information signal containing its reply. This selective reflection (backscatter) impresses or imprints the information signal on the RF waveform, thereby creating a reflected information signal (backscattered reply) that an RFID reader or tester may be able to detect. The RFID tag assembly may perform the backscatter by modulating an impedance or reflectance of its antenna. For example, the RFID tag assembly may switch between different impedance states to modulate a phase and/or a magnitude of a backscattered reply. For communicating with or testing an RFID tag assembly, an RFID reader may transmit an RF waveform. The RFID tag assembly receives the RF waveform and harvests energy from the RF waveform to activate the RFID tag assembly. Activation of the RFID tag assembly may include enabling the IC of the RFID tag assembly to power up and operate. After the RFID tag IC is powered up and operating, it can demodulate and decode commands impressed on the RF waveform by the RFID reader, and can respond by backscattering a reply using the reader-transmitted RF waveform.

UHF RFID applications operate at local frequency bands spread across a range of around 860-960 MHz. Typical reading distance may be up to 10 m depending on, for example, the application environment, the reader performance, and the UHF tag assembly characteristics. Performance tests may occupy a wider frequency range around the application operation frequency range of 860-960 MHz. HF RFID applications most typically operate at a frequency of 13,56 MHz. HF tag assemblies are typically read from a distance of a few millimetres up to some tens of centimetres, depending, for example, on the HF tag assembly characteristics, the communication protocol, and the transceiver coil. Performance tests may occupy a wider frequency range around the nominal frequency of 13,56 MHz.

RFID tag assembly performance tests may be performed in either near-field or far-field. When operating in the far-field, typically over a distance of at least one wavelength (λ) between the transmitting antenna and the RFID tag assembly, the RFID tag assembly works as a reflector and communicates by altering the amount of backscattered field, i.e., by changing the reflection by modulating its impedance. In the near-field, an RFID tag assembly is electrically coupled with the coupling element, inductively through a magnetic field or capacitively through an electric field. The near-field coupling of RFID tag assemblies may be easier to control and restrict, and a near-field coupling element enables, for example, singulation of the RFID tag assembly to be tested. In some situations, a coupling element may physically contact the antenna of an RFID tag assembly being tested. In these situations, RF waveforms (and modulated commands) may be sent to the RFID tag assembly by conduction through the physical (and electrical) contact between the coupling element and the antenna. Similarly, backscatter replies from the RFID tag assembly may be received by conduction through the physical contact. Such coupling elements may include, for example, electrical probes configured to physically (and electrically) contact an antenna of an RFID tag assembly.

In an inline process, where testing is implemented as part of the manufacturing process, the RFID tag assemblies may be provided on a continuous support media, for example a liner or a tape, which is moved over the reading/testing area or zone. The RFID tag assemblies may be uniformly pitched in the support and tested one-by-one. The RFID tag assemblies may pass the reading/testing zone either in continuous fashion or may stop in the zone for the duration of the test, depending on whether the process is continuous or intermittent. The time a single RFID tag assembly exists on or in a reading zone forms a test time window for the RFID tag assembly.

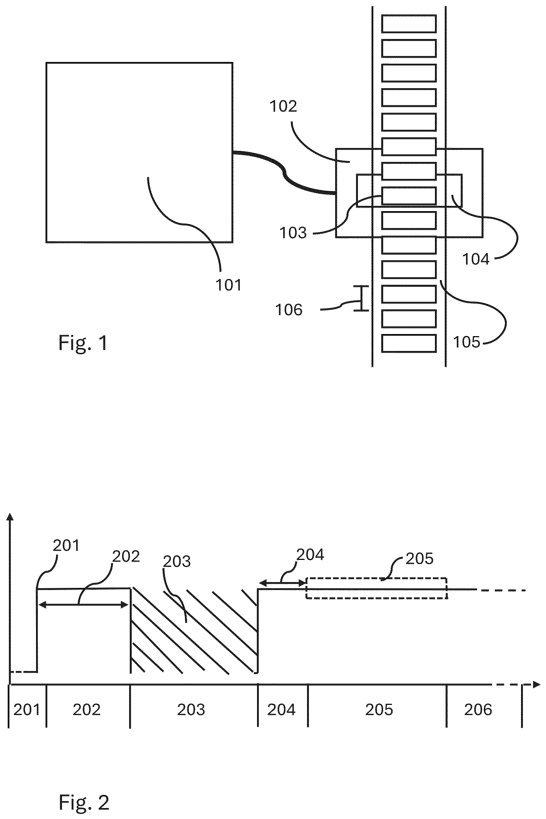

Figure 1 illustrates, by way of an example, a production line test arrangement for RFID tag assemblies. The production test arrangement comprises a tester 101, a coupling element 102, a reading zone 104 of the coupling element 102, an RFID tag assembly to be tested 103 and RFID tag assemblies on a liner 105. The tester 101 is configured to provide an RF waveform, at a chosen frequency and power, to the coupling element 102, which is configured to electrically couple with the RFID tag assembly to be tested 103. The RFID tag assembly to be tested 103 is configured to harvest power from the RF waveform and to activate. The tester 101 is configured to send a command, requesting a reply, to the RFID tag assembly to be tested 103. The command, or information signal, may be modulated on the RF waveform by an RFID reader of the tester, or by another part of the tester. In response to the received command, the RFID tag assembly to be tested 103 is configured to backscatter a reply. The backscattered reply is received by the coupling element 102 and may be recorded by the tester 101 for analysis.

Inline or production testing of RFID tag assemblies is typically performed in the near field using a dedicated near-field coupling element, which provides a defined reading zone. A tester 101 in combination with a coupling element 102 is configured to provide an RF waveform for an RFID tag assembly to be tested 103 and to perform testing while the RFID tag assembly is in the reading zone 104, or preferably while the RFID tag assembly is in the reading zone 104 alone, i.e., when the neighbouring RFID tag assemblies are not in the reading zone 104. The RFID tag assemblies to be tested may be provided for example on a support, a liner 105, or attached on an item. The RFID tag assemblies are separated by a small gap which allows them to be tested individually. The RFID tag assemblies have a leading edge and a trailing edge. The RFID tag assemblies are fed with their leading edge ahead to the reading zone 104 of the coupling element 102. A tag pitch 106 of RFID tag assemblies is a distance between leading or trailing edges of two successive RFID tag assemblies in the liner 105. Tag pitch 106 may be, for example 10 - 60 mm. Alternatively, RFID tag assemblies or tagged items to be tested may be individual and/or separate. In these situations, those tag assemblies, or tagged items, are fed to the reading zone 104 of the coupling element 102 separately, one at the time.

Activation of an RFID tag assembly may refer to the power up and initialization of an RFID tag assembly, thereafter enabling the activated RFID tag assembly to receive and respond to commands. An RFID tag assembly may be activated, for example, by providing an RF waveform to the RFID tag assembly such that the RFID tag assembly may harvest sufficient power from the RF waveform to power an IC and other components of the RFID tag assembly. In such an example, the activated RFID tag assembly can demodulate and decode commands, and appropriately backscatter replies to the commands. A tester may activate an RFID tag assembly by providing an RF waveform to the RFID tag assembly. The tester may wait until the RFID tag assembly is expected to be ready to receive commands from a tester (e.g., until the RFID tag assembly is "active" or "activated") before sending a command to the RFID tag assembly.

Commanding of an RFID tag assembly may include a tester sending a command to an RFID tag assembly such that it is expected to reply by providing a reply of a known length. Commanding may comprise sending a single command, sending multiple commands, or performing a dialog between the tester and the tag assembly to be tested. A test comprising RF waveform alteration may be performed during any suitable response, such as during a last tag assembly reply, during any tag assembly reply, or during multiple tag assembly replies, of a sequence of tag assembly replies.

A typical test time window available in a continuously moving production machine may be, for example 5 - 20 ms for UHF tag assemblies, and 5 - 50 ms for HF tag assemblies, depending on at least the production line speed, the tag assembly antenna dimensions, and tag assembly pitch. The shortest test time windows may only allow a single tester-tag assembly communication cycle, which comprises a power up of the tag assembly with a chosen frequency and power, a brief communication sequence with the tag assembly, and then shutting down the carrier. Alternatively, tag assemblies may be tested in a stop-and-go process, where the tag assembly is kept still for the duration of the testing. Such a process allows more time for testing, but may be unsuitable for a high-throughput production system, as repeated decelerations and accelerations slow down the machine operation and create stress in both tag assembly material and machine parts.

Figure 2 depicts a chart that illustrates, by way of an example, communication between a tester and an RFID tag assembly. The horizontal x-axis of the chart represents time, and the vertical y-axis represents RF waveform power. A tester is configured to provide an RF waveform to activate a tag assembly at a phase 201, to wait at a phase 202 for the tag assembly to be activated. At a phase 203 a modulated RF waveform is transmitted to the tag assembly. The RF waveform may be modulated by the tester or a module of a test system, for example an RFID reader module. The modulated RF waveform may include a command. The tag assembly is configured to harvest energy from the RF waveform starting at the phase 201, and to prepare for operation at the phase 202. The tag assembly is configured to detect the modulated RF waveform at the phase 203. There may be a delay at a phase 204, after the modulated RF waveform is received by the tag assembly. After any possible delay at the phase 204, the tag assembly may be configured to start backscattering a reply at a phase 205. The backscattered reply may be received and optionally recorded by the tester at the phase 205. The backscattered reply may then be processed for analysis and/or to recover data, for example to extract measures of one or more characteristics of the backscatter reply, including magnitude, backscatter phase, or timings of the backscattered reply. The processing may occur while receiving the backscattered reply at the phase 205 and/or after the reply has ended at the phase 206.

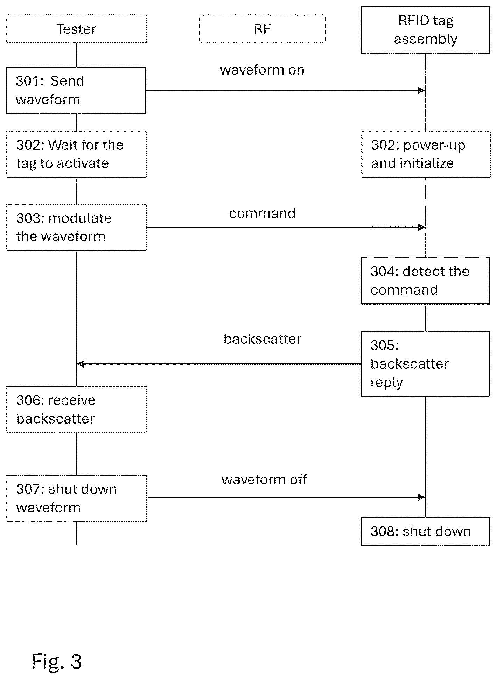

Figure 3 illustrates, by way of an example, signalling between a tester and an RFID tag assembly over a single tester-tag assembly communication cycle. The tester is presented on the left side, the RFID tag assembly on the right side, and signalling between them is presented so that time proceeds downward in Figure 3. The tester is configured to begin sending an RF waveform to the RFID tag assembly at a phase 301. The tester may then wait for a while, at a phase 302, for the RFID tag assembly to be activated. The RFID tag assembly is configured to power-up and initialize (e.g., activate) at the phase 302, in response to receiving and harvesting energy from the RF waveform. At a phase 303, the tester is configured to send a command, for example by modulating the RF waveform. At a phase 304, the RFID tag assembly may detect the command. After the RFID tag assembly has received the command at the phase 304, it backscatters a reply at a phase 305. As described above, the RFID tag assembly may backscatter a reply by modulating an impedance or reflectance of its antenna to create a reflected information signal. At a phase 306, the tester is configured to receive and record or process the backscattered reply. Subsequently, at a phase 307 the tester may terminate or shut down the RF waveform. At a phase 308, due to power usage and no longer receiving an RF waveform to harvest additional power from, the RFID tag assembly may shut down due to a loss of power. The interactions illustrated in the Figure 3, from the phase 301 to the phase 307, may be referred to as a tester-tag assembly communication cycle.

RFID tag assembly operability may be tested by providing an RF waveform at a chosen power and carrier frequency, transmitting a command, and checking whether the tag assembly to be tested responds as expected. A simple communication test like this may be adequate for checking tag assembly operability under specific RF waveform frequency and power conditions. This type of test is quick, as only a single tester-tag assembly communication cycle is required, but it only provides a binary result (pass or fail) and does not provide quantitative information on RFID tag assembly characteristic(s) (e.g., how close one or more characteristic was to certain specified limits).

Measuring an activation threshold of an RFID tag assembly may be preferable. The activation threshold of an RFID tag assembly, also referred to as a tag assembly sensitivity, may refer to the minimum RF waveform power required to activate the tag assembly, e.g. to enable the tag assembly to power up and initialize to get ready to receive commands and reply as intended. The activation threshold depends on, for example, at least one of the following: the RFID tag IC energy consumption, the RFID tag antenna design, and the quality of the RFID tag assembly. Activation threshold measurements, also commonly referred to as sensitivity tests, may provide more detailed information about RFID tag assembly characteristic(s). For example, sensitivity tests may be used to detect possible issues with the RFID tag assembly affecting sensitivity of the RFID tag assembly, such as poor IC bonding quality and antenna construction problems. Furthermore, such measurements may allow tag assembly-to-tag assembly (tag-to-tag) activation threshold variations and drifts over time to be monitored, thereby enabling the detection of accumulating issues in the manufacturing process.

An activation threshold of an RFID tag assembly may be measured by providing an RF waveform having a certain carrier frequency for the RFID tag assembly to be tested and by attempting communication with the tag assembly at different RF waveform power levels to find the minimum power required to successfully activate the tag assembly. A communication test may be performed, for example, by providing the RF waveform at a chosen power and carrier frequency, transmitting a command, and checking whether the tag assembly to be tested responds as expected. A successful response indicates that the power level is adequate for tag assembly activation. Otherwise, the power level may be too low. A simple method to measure an activation threshold of a tag assembly is to iteratively perform communication tests, starting from a low RF waveform power level and increasing the power level step by step until the tag assembly responds, or in other words is activated successfully. However, this method can be relatively slow due to its iterative nature, even if iteration-reducing techniques such as smart threshold finding algorithms are employed, thereby limiting its feasibility for inline use during a production process. Moreover, longer measurement may cause greater variability in RF waveform power level at the tested tag assembly due to tag assembly movement along the production line, thereby resulting in greater measurement uncertainty.

An activation threshold of an RFID tag assembly may be derived from a deactivation threshold of the RFID tag assembly, or the deactivation threshold may be measured and used as such for validating performance of the RFID tag assembly. A deactivation threshold of an RFID tag assembly refers to the RF waveform power level where the (activated) RFID tag assembly can no longer harvest enough energy to maintain operation. A deactivation threshold of an RFID tag assembly is related to, and in fact may be the same as, an activation threshold of the RFID tag assembly. A deactivation threshold of an RFID tag assembly may be measured, for example, by providing an RF waveform having a certain carrier frequency to the RFID tag assembly to be tested and by attempting communication with the tag at lowering RF waveform power levels to find the minimum power required to successfully activate the RFID tag assembly. The initial waveform power must be adequate to activate the RFID tag assembly. The carrier power is not shut down between tests but adjusted down in a step-by-step process while attempting to communicate after each adjustment, until the RFID tag assembly deactivates and won't backscatter a reply anymore. This kind of a test process is simple but may be slow especially if the threshold is searched at high resolution, i.e., if the adjustment steps are relatively small.

There is provided a test for RFID tag assemblies, which enables avoiding drawbacks of iterative test methods. The power of an RF waveform may be adjusted or altered to test characteristic(s) of an RFID tag assembly. RF waveform power alterations may be accomplished by, for example, changing the modulator drive level or the transmitter gain. Analysis of a backscattered reply during alteration of the waveform power enables investigation of characteristics of the backscattered reply, such as amplitude, phase, duration, start, end, frequency, bitrate, or any aspect of waveform shape, and their changes in relation to the altered power. Characteristics of an RFID tag assembly are determined based on change(s) in the backscattered reply. Testing by altering waveform power during the tag assembly backscattering saves time, because the testing does not need to be performed by repeating the test command at each of multiple waveform power levels.

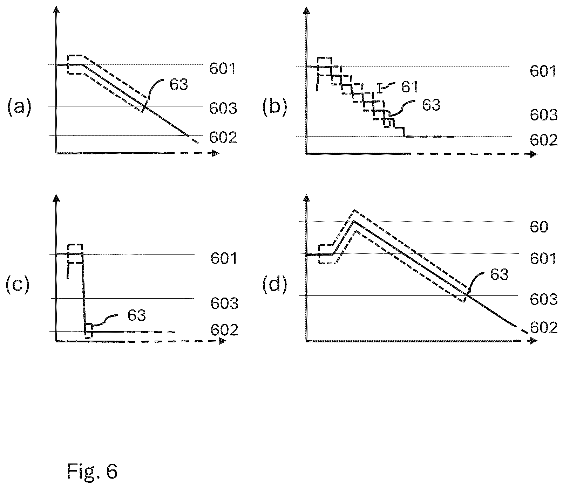

A deactivation threshold of an RFID tag assembly may be measured by performing an RF waveform power ramp-down test. In an RF waveform power ramp-down test, the RFID tag assembly to be tested is first activated with an RF waveform having a first power level. The RF waveform power is then adjusted downward according to a power reduction curve while the tag assembly is backscattering a reply to a test command. A power reduction curve dictates how RF waveform power is reduced, examples of which may include a step function, a staircase function, a continuous slope ramp, a variable slope ramp, or any other suitable function describing a generally downwards trending shape. Further details of power reduction curves are described below in reference to Figure 6. When the RF waveform power falls below the deactivation threshold of the tag assembly, the tag assembly may stop backscattering. The deactivation threshold may then be measured based on the RF waveform power at which the tag assembly stopped backscattering. The difference between the RF waveform power level at which the tag assembly stops backscattering and the first power level may be referred to as a "margin". Deactivation threshold measured by the ramp-down test may differ from deactivation threshold measured by iteration, because the first is based on the RFID tag assembly's capability to keep backscattering, while the latter is based on the energy needed to receive command and then reply.

The length of the received backscatter reply may also, or instead, be used to determine the deactivation threshold of the tag assembly, or to determine a relative deactivation threshold. As described, an RFID tag assembly that is backscattering a reply may stop backscattering when an RF waveform from which the tag assembly harvests operating power drops below a certain power level, even if the tag assembly has not finished backscattering the entire reply. Accordingly, for a power reduction curve having a particular power ramp-down rate, the length of a backscatter reply received from a tag assembly may be proportional to the sensitivity of the tag assembly. Said another way, the more sensitive a tag assembly is (e.g., the deactivation threshold is a relatively low power), the longer it is able to continue backscattering before the power level drops below the deactivation threshold and the tag assembly stops backscattering. A reference tag assembly matching with minimum specifications may be tested to measure a reference response backscatter reply length, to which the test results of other tag assemblies may be compared to. In this example, when testing a tag assembly, a backscatter reply length of the tested tag assembly may be used to directly derive a deactivation threshold of a tag assembly or sensitivity, or the backscatter reply length may be compared to the reference backscatter reply length to determine a relative deactivation threshold or sensitivity.

An RF waveform power ramp-down test as described above may be used to determine tag assembly activation threshold and/or deactivation threshold, to assess assembly-to-assembly (tag-to-tag) sensitivity variation and to detect defective tag assemblies which fail to meet production quality specifications. A power ramp-down test may be executed in a single communication cycle and deactivation threshold detection may provide measured information on tag assembly sensitivity. A ramp-down test may be faster than conventional, direct, iterative sensitivity tests and may also provide more tag data on characteristics of an RFID tag assembly than a simple communication test.

One complication to tag assembly deactivation threshold measurement is that RFID tag assembly ICs often have energy storage in the form of in-built capacitances, which may store energy and therefore allow tag assembly ICs to operate beyond their deactivation thresholds. Energy may be stored when a tag assembly harvests energy from an RF waveform. This stored energy may be used to power the tag assembly when the RF waveform power falls below the activation threshold. A tag assembly's (or tag's) discharge time refers to the time it takes for the total power available to the tag from both its energy storage and the RF waveform to drop below the power necessary for the tag assembly to operate, after the RF waveform power has dropped below the tag assembly's activation threshold. A tag assembly's discharge time may be, for example, 50 - 200 µs, depending on at least one of the following: the amount of energy stored, the current power consumption of the RFID tag IC, and the amount of energy or power the tag assembly is still able to harvest from the RF waveform. The discharge time varies with the stored energy and RF waveform power (to a lesser degree) - more stored energy and/or a higher RF waveform power results in a longer discharge time, while less stored energy and/or a lower RF waveform power results in a shorter discharge time. As a result, the RF waveform power level at which an RFID tag assembly stops backscattering may not reflect its deactivation threshold, because the tag assembly will continue backscattering for some time (the discharge time) after the RF waveform power drops below the tag assembly's deactivation threshold. Accordingly, determining a tag assembly's deactivation threshold may not only require knowing the RF waveform power level at which the tag assembly stopped backscattering, but may also require knowing the history of the RF waveform power and the tag assembly's discharge time, which itself is also based on at least the RF waveform power history.

The operating voltage of the RFID tag IC may be clamped at, for example, 1-3 dB above an activation threshold of the tag to protect the IC of the tag against, for example, an excess carrier and/or an electro-static discharge. This voltage clamping sets a practical limit for the energy stored, and therefore the discharge time, when the RF waveform power is high. However, the power dependency of the discharge time may be considered when testing close to the activation threshold.

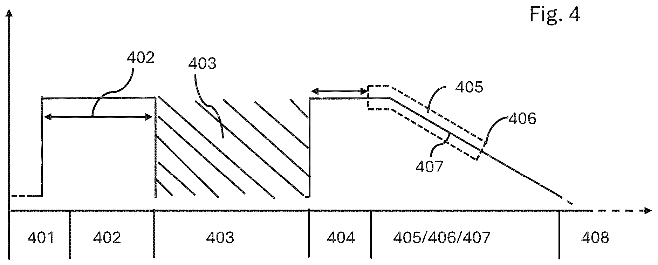

Figure 4 illustrates a chart that illustrates, by way of an example, communication between a tester and an RFID tag assembly with the tester performing a power ramp-down test. In Figure 4 the tester alters RF waveform power while the tag assembly is backscattering its reply. The horizontal (with respect to the text) x-axis of the chart represents time, and the vertical (with respect to the text) y-axis represents waveform power. A tester-tag assembly communication cycle is started by the tester setting up and starting to send an RF waveform at a phase 401. The tester is configured to continue sending the RF waveform to activate the tag assembly to be tested at a phase 402, to send a command at a phase 403, to wait for the tag assembly to reply at a phase 404, and to receive and record and/or process a backscattered reply from the tag assembly at a phase 405. The tag assembly is configured to activate in response to receiving the RF waveform at the phase 402, to detect the sent command at the phase 403, and to start backscattering a reply at the phase 405. While the tag assembly is backscattering at the phase 405, the tester alters the power of the RF waveform at a phase 407. In this example, the tester alters the power of the RF waveform by ramping down the power at a certain rate (indicated by a steady slope) at the phase 407. The tag assembly is configured to harvest power from the RF waveform, while the power available is decreasing as the RF waveform power ramps down. When the RF waveform power passes below a deactivation threshold, the tag assembly will eventually stop backscattering at a phase 406. The tester may then stop sending the RF waveform at a phase 408.

RF waveform power altering may comprise, for example, ramping down the power according to a power reduction curve that may be continuous (e.g., ramping power down according to a continuous slope as shown in Figure 4) or otherwise (e.g., a stepwise function with one or more steps). The alteration strategy chosen affects the performance of the analysis, dynamic range and resolution of the test, and the measurements which may be extracted from the backscatter signal. Continuous or staircase (e.g., in multiple discrete steps) power reduction curves enable detection and measurement of an RFID tag assembly deactivation threshold, and analysis of backscatter changes in relation to the RF waveform power. Reducing power in a single step (e.g., a single step power reduction curve) does not enable analysis with respect to the RF waveform power but may be used to test characteristics of an RFID tag assembly when the RF waveform is shut down.

RF waveform power alteration may be synchronized with the tag assembly reply. In this testing, analytic information may only be conveyed through tag assembly backscatter. Accordingly, any power ramp-down for testing purposes may not start before the tag assembly starts backscattering. To enable the detection of prematurely ended tag assembly replies, the entire test range should be traversed before the end of the expected end of the tag assembly reply to enable detection of a prematurely terminated reply. The timing and length of the tag assembly backscatter depends on the reply data, as well as a modulation type (of the RF waveform), and a back-link frequency, which may be configured by the tester. A back-link frequency corresponds to a bit rate of the tag assembly reply.

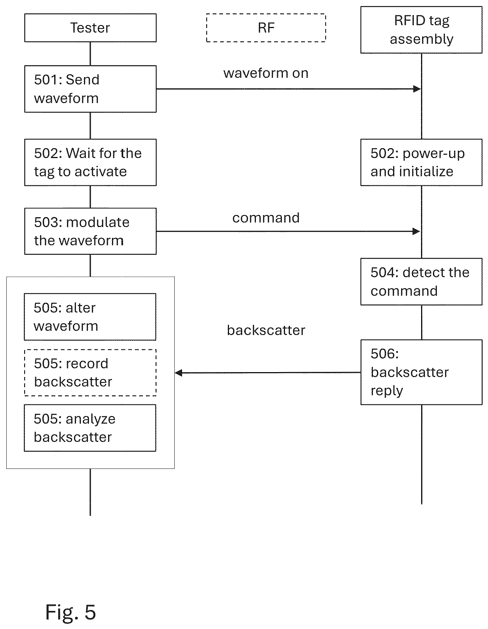

Figure 5 illustrates, by way of an example, signalling between a tester and an RFID tag assembly with a tester performing waveform altering while the RFID tag is backscattering. The tester is presented on the left side, the RFID tag assembly on the right side, and signalling between them is presented so that time progresses downward in Figure 5. The tester is configured to begin sending an RF waveform to the RFID tag assembly at a phase 501. The tester may wait for a while, at a phase 502, for the RFID tag assembly to be activated. The RFID tag assembly is configured to power-up and initialize at phase 502, in response to receiving and harvesting energy from the RF waveform. At a phase 503, the tester is configured to send a command, for example by modulating the RF waveform. At a phase 504, the RFID tag assembly may detect the command. After the RFID tag assembly has received the command at phase 504, it starts to backscatter a reply at phase 506. At a phase 505, after the RFID tag assembly has begun backscattering a reply, the tester is configured to alter one or more features of the RF waveform (e.g., the RF waveform power), optionally record the backscattered reply, and analyse the backscattered reply. Subsequently, the RF waveform may be terminated or shut down. In addition, or alternatively, analysis of the backscattered reply may be performed after the phase 505, for example, by measuring properties of the backscattered reply to determine a characteristic of the RFID tag assembly.

Figure 6a illustrates, by way of an example, a ramp power reduction curve where RF waveform power is altered from an initial level 601 to a minimum level 602 and beyond following a continuous slope. A tester implementing the ramp power reduction curve may alter the RF waveform continuously, consistently dropping the RF waveform power at a specific rate. An RFID tag assembly with a deactivation threshold corresponding to a level 603 and in the process of backscattering a reply may stop backscattering at 63, as the RF waveform power reaches the level 603. The RF waveform power ramp-down rate, visually depicted as the angle of the downward slope, may be selected based on a desired or expected reply length, a targeted dynamic range of the test, and/or a desired analysis time resolution. A faster power ramp-down rate, corresponding to a steeper slope, allows a larger dynamic range to be tested at the expense of time resolution. A slower power ramp-down rate, corresponding to a shallower slope, allows better time resolution at the expense of dynamic range. In addition, the power ramp-down rate must be fast enough to drop below the minimum detection level desired before the tag assembly reply is expected to end, to ensure detection of the end of the tag assembly reply.

Figure 6b illustrates, by way of an example, a stepwise or staircase power reduction curve, where RF waveform power is altered downward from the initial level 601 to the minimum level 602 in multiple steps 61. Each one of the steps 61 may have the same or different durations (lengths) and/or sizes (heights). A tester implementing the staircase power reduction curve may alter the RF waveform periodically, dropping the RF waveform power by a consistent amount after a consistent time interval. An RFID tag assembly with a deactivation threshold corresponding to the level 603 may stop backscattering at 63, as the RF waveform power has dropped below the level 603. In Figure 6b, the RF waveform power alteration is made in steps, and analysis may be performed at one step, at multiple steps, or separately at each step.

RFID tag assembly testing using a continuous power reduction curve, while allowing relatively fine control of dynamic range and time resolution, may have to contend with deactivation threshold measurement offsets due to RFID tag assembly discharge time. Testing using a stepwise or staircase power reduction curve allows the effects of RFID tag assembly discharge time on deactivation threshold measurements to be reduced or even eliminated, depending on the step duration. For example, if the steps have durations long enough such that the RFID tag assembly, if harvesting power below its activation threshold, will end up fully using any stored energy, then the effect of the stored energy on the detection of the tag assembly deactivation threshold may be significantly reduced. If not, then stored energy effects (e.g., represented by discharge time) may need to be considered in determining the deactivation threshold of the tag assembly. Stepwise power alteration may however be slower and require compromising between dynamic range and power resolution to be able to complete testing with a single tag assembly reply.

Figure 6c illustrates, by way of an example, a single step power reduction curve, where RF waveform power is reduced from the initial level 601 to the minimum level 602 in a single step. A tester implementing the single step power reduction curve may alter the RF waveform only one time, dropping the RF waveform power from the initial level 601 to a deactivation level 603, for example, during expected tag assembly reply. An RFID tag assembly being tested may stop backscattering at 63 as the RF waveform power drops below the deactivation level 603. The single-step adjustment depicted in Figure 6c generally will not allow detection of a deactivation threshold of an RFID tag assembly, but may be used, for example, to investigate tag assembly energy storage and discharge time with respect to RF waveform power.

As mentioned above, RFID tag assembly supply voltage may be clamped, for example, at 1 - 3 dB above the activation threshold. Accordingly, an RF waveform power boost of 2 - 4 dB RF (for example) before ramping down may allow an RFID tag IC to charge its internal energy storage sufficiently to significantly reduce the impact of the initial RF waveform power level (excluding the boost) on the tag IC's discharge time. This may improve the accuracy of the deactivation threshold measurement performed using an initial RF waveform power close to the activation threshold of the tag assembly and/or to enable adjustment of the test results to provide more accurate analysis, for example, for an estimate of the activation threshold, or the tag assembly sensitivity.

Figure 6d illustrates, by way of an example, a ramp power reduction curve with an initial power boost. The RF waveform power is first boosted from the initial level 601 up to a level 60 and is then ramped down to the minimum level 602 and beyond following a continuous slope. An RFID tag assembly being tested stops backscattering at 63 as the RF waveform power drops below the deactivation level 603. Boosting the RF waveform power before ramping down the RF waveform power attempts to saturate IC energy storage, or push the discharge time to, or close to, its maximum.

However, using a pyramidal waveform pattern such as illustrated in Figure 6d may take more time than a simple ramp-down pattern. An alternative time-saving approach may involve choosing an initial power level which is 2 - 4 dB above the intended maximum level to allow a tag assembly to charge its internal energy storage at the start of the test, and the test data may be reported starting from the original intended level. The power boost may also occur at an earlier stage of the tester-tag assembly communication cycle, for example when the tester is beginning to send the RF waveform (phase 501), when the tester is waiting for the tag assembly to initialize (phase 502), and/or when the tester is modulating the waveform to send a command (phase 503).

A tester transmitting an RF waveform to a tag assembly may alter the RF waveform according to a power reduction curve like those depicted in Figures 6a-d, or any other suitable power reduction curve. For example, other examples of power reduction curves may include logarithmic reduction curves, damped sinusoidal curves, or combinations of two or more types of power reduction curves.

The effects of tag assembly energy storage (i.e., discharge time) may be compensated for, at least partly, by performing a reference measurement with a valid tag assembly sample to characterize typical tag assembly operation and adjusting measurement results accordingly. The reference test may comprise, for example, measuring tag assembly reply length at a known offset above the activation threshold of the tag assembly. In that case, reply length may be recorded in the production test, and any differences to the reference may be used to define the margin for the activation threshold. If the measured reply length of the tested tag assembly matches that of the reference tag assembly, the deactivation thresholds of the two will also match. If the measured reply length of the tested tag assembly is longer or shorter than that of the reference tag assembly, then the deactivation threshold of the tag assembly is lower or higher, respectively, than the deactivation threshold of the reference tag assembly. Moreover, as the ramp-down rate is known, the sensitivity difference may be calculated from the difference of the reply lengths. The valid reference tag assembly needs to be a qualified sample of the same kind as the tag assemblies to be tested. The power reduction curve used in the reference test should be consistent with the power reduction curve that is used in the measurement to be compensated.

Reference data may be acquired separately, for example, for multiple RF waveform frequencies, waveform power levels, or a combination of any suitable RF waveform features to provide for more comprehensive adjustment. If discharge time is constant or stabilized, for example by using power boosting, a single reference value may be adequate. Otherwise, or to minimize measurement uncertainty, more detailed characterization may be used.

The reference test and the measurement may be performed inline, as part of a production process, to avoid pre-characterization. Such implementation may include performing a reference test before the actual production test. The same RF waveform power, frequency, and power-reduction-curve-type are applied in both tests, except that the power ramp-down rate of the reference power reduction curve in the production test may be slightly different. The deactivation threshold of the tag assembly is measured in both the reference test and the production test, and their difference may be used to determine the discharge time of the tag assembly. Once the discharge time is determined, it can be used to adjust measured deactivation threshold of the tested tag assemblies.

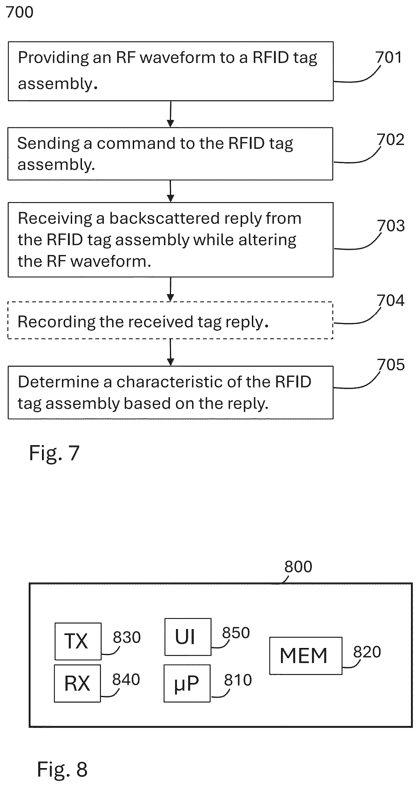

An RF waveform may be altered, in addition to waveform power, for example, by altering frequency, phase, polarization, sidebands, subcarriers, spectrum, or other waveform features. Investigation of tag assembly backscatter characteristics with respect to frequency, for example, may provide information on tag assembly tuning, resonant frequencies, and/or bandwidth, which may be used to detect defective tag assemblies. When testing the effects of these other waveform features, the same requirements described above for test timing of power alterations with respect to tag assembly backscatter timings and length may apply. Figure 7 illustrates, by way of an example, a method 700 for testing at least one characteristic of an RFID tag assembly. Method 700 begins by a tester providing an RF waveform to an RFID tag assembly at a phase 701. The RF waveform is configured to provide sufficient energy harvestable by the RFID tag assembly to activate the RFID tag assembly. The tester may send a command to the RFID tag assembly at a phase 702 by modulating the RF waveform. The RFID tag assembly is configured to backscatter a reply after receiving the modulated RF waveform. At a phase 703, the tester alters some aspect of the RF waveform while receiving the backscattered reply. At an optional phase 704 the backscattered reply is recorded, which may occur before, after, and/or while the tester is the RF waveform is altered. The RF waveform may be altered by the tester, i.e., the test system, for example by a reader or another component of the test system. The tester may measure a change in the backscatter reply, for example, by measuring properties of the backscattered reply, for example a backscatter amplitude, phase, duration, start, end, frequency, bitrate, or any aspect of waveform shape and their change in relation to the altering of the RF waveform. At a phase 705, characteristics of the RFID tag assembly are determined based on the change in the backscattered reply and the RF waveform alteration.

Figure 8 illustrates, by way of an example, a test apparatus for testing at least one characteristic of an RFID tag assembly. The test apparatus 800 includes a processor 810, which may comprise, for example, a single- or multi-core processor. The processor 810 may comprise a control device, or the processor 810 may be a control device. The processor 810 may comprise at least one application-specific integrated circuit, ASIC, and/or at least one field-programmable gate array, FPGA. The processor 810 may form, at least partly, means for performing method steps in the test apparatus 800. The processor 810 may be configured, at least in part, by computer readable instructions, to perform actions, like a method as discussed with Figure 7. The test apparatus of Figure 8 comprises a memory 820. The memory 820 may comprise random-access memory and/or permanent memory. The memory 820 may be at least in part accessible by processor 810. The memory 820 comprises means for storing information. The memory 820 may comprise computer instructions that processor 810 is configured to execute. When computer instructions configured to cause processor 810 to perform certain actions are stored in memory 820, and the test apparatus 800 is configured to run under the direction of the processor 810 using computer instructions from the memory 820, the processor 810 may be considered to cause the test apparatus to perform the certain actions. The memory 820 may be at least in part external to test apparatus 800 but accessible to the test apparatus 800. The test apparatus 800 may comprise a transmitter 830. The test apparatus 800 may comprise a receiver 840. The transmitter 830 and the receiver 840 are configured to transmit and receive, respectively, RF waveforms that may include commands and backscattered replies. The device 800 may comprise a user interface, UI, 850. UI 850 may comprise at least one of a display, a keyboard, a touchscreen, a speaker and a microphone. A user can operate device 800 via the UI 850. The apparatus of Figure 8 is illustrated as single entity. Different units, processors and/or memory units may be implemented inside test apparatuses, to enable the functioning thereof. Analysing may be implemented in the test apparatus, and/or a separate computer may be used for analysis.

Test and analyses described above may also be used for testing active or battery-assisted RFID tag assemblies. In these situations, the RFID tag assembly may continue operating despite of RF waveform power dropping. This may make it impossible or irrelevant to measure deactivation power of the active RFID tag assembly, but other characteristics of the RFID tag assembly may be measured.

The previously presented aspects, embodiments, examples and ways of implementation are illustrated to show possible realizations, where obvious changes and modifications are possible. The invention is not limited to any specific example or illustration, but to the following independent claims.

The verbs "to comprise" and "to include" are used in this document as open limitations that neither exclude nor require the existence of also un-recited features. The features recited in dependent claims are mutually freely combinable unless otherwise explicitly stated. Furthermore, it is to be understood that the use of "a" or "an", i.e., a singular form, throughout this document does not exclude a plurality.

## Claims

1. A method for determining at least one characteristic of an RFID tag assembly comprising at least an integrated circuit, IC, the method comprising:
providing, from a test reader, an RF waveform to the IC (701);
receiving, at the test reader, a backscattered reply from the IC, wherein the IC forms the backscattered reply by impressing an information signal on the RF waveform;
**characterized in that**
while receiving the backscattered reply, the RF waveform is altered (703), thereby causing a change in the backscattered reply;
measuring the change in the backscattered reply; and
determining the characteristic based on the measured change caused by the altering.

2. The method according to the claim 1, wherein the RFID tag assembly comprises at least one of the following: an RFID tag including the IC coupled to an antenna; a part of an RFID tag including at least the IC; an incomplete RFID tag including the IC attached on a media; the IC attached to a conductor loop; the IC attached to a strap; and the IC attached to a conductive element configured to form an antenna of the RFID tag.

3. The method according to the claim 1 or 2, wherein the RF waveform includes a modulated command configured to instruct the IC to send the backscattered reply.

4. The method according to any one of the claims 1-3, wherein providing the RF waveform to the IC comprises sending the RF waveform through an electrically conductive, physical connection to the RFID tag assembly; or
wherein providing the RF waveform to the IC comprises transmitting the RF waveform wirelessly.

5. The method according to any one of the claims 1-4, wherein altering the RF waveform comprises at least one of the following: altering at least one of the following: a power, a frequency, a polarization, a phase, a sideband, a subcarrier, and a spectrum of the RF waveform.

6. The method according to any one of the claims 1-5, wherein altering the RF waveform comprises performing one of the following: performing a one-time alteration, performing multiple alterations, and performing a continuous alteration.

7. The method according to any one of the claims 1-6 wherein measuring the change in the backscattered reply comprises one or more of: measuring at least one property of the backscattered reply, and measuring a change of the at least one property of the backscattered reply.

8. The method according to the claim 7, wherein the at least one property includes at least one of: an amplitude, a phase, a duration, a length, a start, an end, a frequency, a bitrate, and a waveform shape related aspect of the backscattered reply.

9. The method according to any one of the claims 1-9, further comprising recording the backscattered reply in a memory before, after, and/or while altering the RF waveform.

10. The method according to any one of the claims 1-9, wherein the characteristic includes one or more of: a deactivation threshold of the RFID tag assembly, an activation threshold of the RFID tag assembly, a sensitivity of the RFID tag assembly, a charge state of an energy storage of the RFID tag assembly, a tuning of the RFID tag assembly, a bandwidth of the RFID tag assembly, and a resonant frequency of the RFID tag assembly.

11. The method according to any one of the claims 1-10, further comprising, before altering the RF waveform, boosting a power of the RF waveform to charge an energy storage of the RFID tag assembly.

12. The method according to any one of the claims 1-11, wherein:
altering the RF waveform comprises reducing a power of the RF waveform; and
the characteristic includes one or more of a deactivation threshold of the RFID tag assembly, a sensitivity of the RFID tag assembly, and an activation threshold of the RFID tag assembly.

13. The method according to the claim 12, further comprising determining the characteristic based on at least one of the following:
- a power reduction curve of the RF waveform, and
- a discharge time associated with an energy storage of the RFID tag IC.

14. The method according to the claim 13, wherein the discharge time is determined based on at least a reference test using a second power reduction curve.

15. The method according to any one of the claims 1-14, wherein:
altering the RF waveform comprises altering a frequency of the RF waveform; and
the characteristic includes one or more of: a tuning of the RFID tag assembly, a bandwidth of the RFID tag assembly, and a resonant frequency of the RFID tag assembly.

16. A test system (101) for testing characteristic of an RFID tag assembly (103) including an RFID tag IC, the test system (101) configured to:
provide an RF waveform to the RFID tag IC (701);
receive a backscattered reply from the RFID tag IC;
**characterized in that** the test system (101) is configured to:
alter the RF waveform, responsive to receiving the backscattered reply (703), and thereby to cause a change in the backscattered reply;
measure the change in the backscattered reply; and
determine the characteristic based on the measured change caused by the altering.

17. A test system comprising means for causing the method according to any one of the claims 1-17 to be performed.

18. A non-transitory computer readable medium having stored thereon a set of computer readable instructions that, upon execution by at least one processor, cause the method according to any one of the claims 1-15 to be performed.
